# FASCICULE DE BREVET EUROPEEN

(11) **EP 3 646 391 B1**
(45) Date de publication et mention de la délivrance du brevet: **13.03.2024**
(21) Numéro de dépôt: 18737689.2
(22) Date de dépôt: 19.06.2018
(51) Int. Cl.: H01L 33/08, H01L 33/18, H01L 33/24, H01L 33/40, H01L 33/48, H01L 33/38, H01L 33/00, H01L 33/42, H01L 33/44, H01L 33/62

(54) **DISPOSITIF OPTOÉLECTRONIQUE ET PROCÉDÉ DE FABRICATION D'UN DISPOSITIF OPTOÉLECTRONIQUE**
OPTOELEKTRONISCHE VORRICHTUNG UND VERFAHREN ZUR HERSTELLUNG EINER OPTOELEKTRONISCHEN VORRICHTUNG
OPTOELECTRONIC DEVICE AND A METHOD FOR MANUFACTURING AN OPTOELECTRONIC DEVICE

(30) Priorité: 30.06.2017 FR 1756149
(43) Date de publication de la demande: 06.05.2020
(73) Titulaire: Aledia, 38130 Echirolles (FR)
(72) Inventeur: GIBERT, Philippe, 38960 St Etienne de Crossey (FR); GILET, Philippe, 38470 Têche (FR); HENAFF, Ewen, 38600 Fontaine (FR); LACAVE, Thomas, 38000 Grenoble (FR)
(74) Mandataire: Cabinet Beaumont
(86) Numéro de dépôt international: PCT/FR2018/051471
(87) Numéro de publication internationale: WO 2019/002720

(56) Documents cités:
- WO-A1-2015/044622
- US-A1- 2003 180 977
- US-A1- 2016 087 151

## Description

La présente demande de brevet revendique la priorité de la demande de brevet français FR17/56149.

### Domaine

La présente invention concerne de façon générale les dispositifs optoélectroniques à base de matériaux semiconducteurs et leurs procédés de fabrication.

### Exposé de l'art antérieur

Par dispositifs optoélectroniques, on entend des dispositifs adaptés à effectuer la conversion d'un signal électrique en un rayonnement électromagnétique ou inversement, et notamment des dispositifs dédiés à la détection, la mesure ou l'émission d'un rayonnement électromagnétique ou des dispositifs dédiés à des applications photovoltaïques.

On s'intéresse plus particulièrement ici à des dispositifs optoélectroniques de type radiaux comprenant des éléments semiconducteurs tridimensionnels et une couche active formée à la périphérie de chaque élément tridimensionnel. On appelle couche active du dispositif optoélectronique la région depuis laquelle est émise la majorité du rayonnement électromagnétique fourni par le dispositif optoélectronique ou est captée la majorité du rayonnement électromagnétique reçu par le dispositif optoélectronique.

Des exemples d'éléments tridimensionnels sont des microfils ou nanofils comprenant un matériau semiconducteur à base d'un composé comportant majoritairement au moins un élément du groupe III et un élément du groupe V (par exemple du nitrure de gallium, GaN), appelé par la suite composé III-V, ou comportant majoritairement au moins un élément du groupe II et un élément du groupe VI (par exemple de l'oxyde de zinc, ZnO), appelé par la suite composé II-VI. De tels dispositifs sont, par exemple, décrits dans les brevets US 9 245 948 et US 9 537 044.

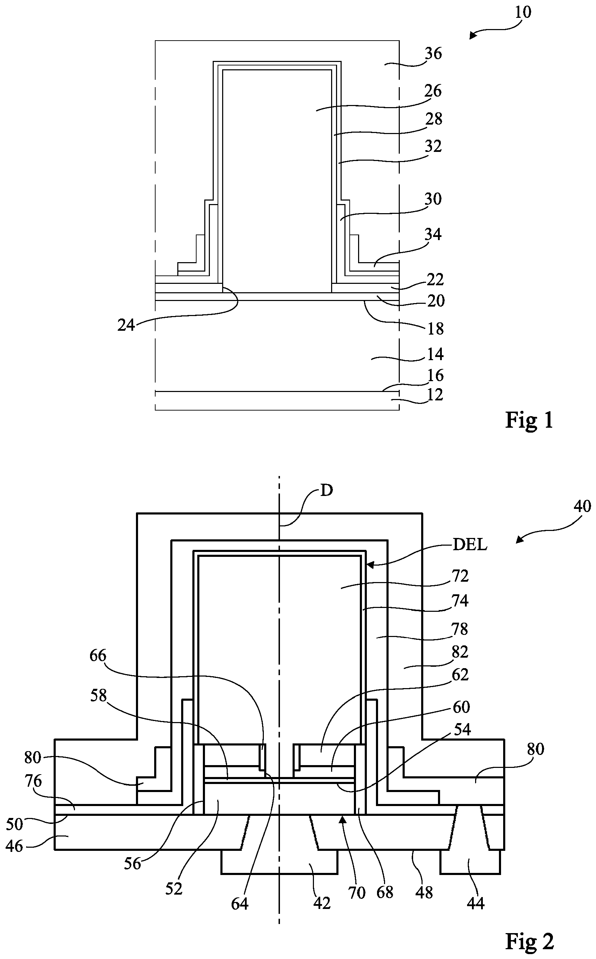

La figure 1 est une coupe, partielle et schématique, d'un dispositif optoélectronique 10 adapté à émettre un rayonnement électromagnétique et dans lequel les éléments semiconducteurs correspondent à des nanofils ou des microfils.

Le dispositif 10 comprend, du bas vers le haut en figure 1 :
une première électrode de polarisation 12 ;
un substrat 14, par exemple semiconducteur, comprenant des faces parallèles 16 et 18, la face 16 étant au contact de l'électrode 12 ;
une couche de nucléation 20 recouvrant la face 18 ;
une couche isolante électriquement 22 recouvrant la couche de nucléation 20 et comprenant des ouvertures 24, une seule ouverture 24 étant représentée en figure 1, aux emplacements souhaités des fils ;
des fils 26, un seul fil 26 étant représenté, chaque fil 26 étant en contact avec la couche de nucléation 20, dans l'une des ouvertures 24 ;
une coque 28 recouvrant la paroi extérieure de chaque fil 26, la coque 28 comprenant la couche active ;
une couche isolante électriquement 30 recouvrant la périphérie d'une portion inférieure de chaque coque 28 ;
une couche 32 conductrice électriquement et transparente au rayonnement émis par la couche active, recouvrant chaque coque 28, chaque couche isolante 30 et la couche isolante 22 entre les fils 26 ;
une couche 34 conductrice électriquement et réfléchissante au rayonnement émis par la couche active, s'étendant sur la couche 32 entre les fils 26 et formant la seconde électrode ; et
une couche d'encapsulation 36 isolante électriquement et transparente au rayonnement émis par la couche active et recouvrant l'ensemble de la structure.

L'ensemble formé par chaque fil 26 et la coque 28 le recouvrant forme une diode électroluminescente. La couche isolante 30 permet d'éviter, pour chaque diode électroluminescente, les fuites électriques dans la partie inférieure du fil 26. La couche conductrice 34 sert à diffuser le courant vers l'ensemble des diodes électroluminescentes et à réfléchir les rayons lumineux émis par les diodes électroluminescentes.

Le procédé de fabrication de la couche conductrice 34 impose généralement que la couche conductrice 34 recouvre une partie inférieure de chaque fil 26.

L'efficacité d'extraction d'un dispositif optoélectronique est généralement définie par le rapport entre le nombre de photons qui s'échappent du dispositif optoélectronique et le nombre de photons émis par les diodes électroluminescentes. Il est souhaitable que l'efficacité d'extraction d'un dispositif optoélectronique soit la plus élevée possible.

Un inconvénient du dispositif optoélectronique 10 est qu'une fraction des photons émis par chaque diode électroluminescente est réfléchie vers l'intérieur du fil 26 par la couche conductrice 34 et ne s'échappe pas du dispositif optoélectronique 10.

Un autre inconvénient du dispositif 10 est que, pour commander indépendamment une diode électroluminescente ou un groupe de diodes électroluminescentes, il faut former des tranchées d'isolation électrique dans le substrat 14 pour isoler, pour ladite diode électroluminescente ou ledit groupe de diodes électroluminescentes, la portion du substrat 14 reliant l'électrode 12 aux fils 26. Les procédés de formation de tranchées d'isolation électrique peuvent être complexes et limitants concernant l'intégration globale du produit visé.

Les documents US 2016/087151 et WO 2015/044622 décrivent chacun des dispositifs optoélectroniques de type radiaux comprenant des éléments semiconducteurs tridimensionnels et une couche active formée à la périphérie de chaque élément tridimensionnel.

### Résumé

Ainsi, un objet d'un mode de réalisation est de pallier au moins en partie les inconvénients des dispositifs optoélectroniques décrits précédemment et de leurs procédés de fabrication.

Un autre objet d'un mode de réalisation est d'augmenter l'efficacité d'extraction du dispositif optoélectronique.

Un autre objet d'un mode de réalisation est d'améliorer la diffusion du courant vers les diodes électroluminescentes.

Un autre objet d'un mode de réalisation est de faciliter la réalisation d'une commande indépendante des diodes électroluminescentes.

Ainsi, un mode de réalisation prévoit un dispositif optoélectronique selon la revendication 1.

D'autres modes de réalisation préférés du dispositif optoélectronique sont définis dans les revendications dépendantes 2 à 10.

Un mode de réalisation prévoit également un procédé de fabrication d'un dispositif optoélectronique selon la revendication 11.

D'autres modes de réalisation préférés du procédé de fabrication d'un dispositif optoélectronique sont définis dans les revendications dépendantes 12 à 15.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1, décrite précédemment, est une vue en coupe, partielle et schématique, d'un exemple de dispositif optoélectronique à microfils ou nanofils ;
les figures 2 à 6 sont des vues en coupe, partielles et schématiques, de modes de réalisation d'un dispositif optoélectronique à microfils ou nanofils selon l'invention revendiquée ;
les figures 7 et 8 sont des vues de dessus, partielles et schématiques, de modes de réalisation du dispositif optoélectronique représenté en figure 6 ;
les figures 9A à 9K sont des coupes, partielles et schématiques, de structures obtenues à des étapes successives d'un mode de réalisation d'un procédé de fabrication du dispositif optoélectronique selon l'invention revendiquée qui est représenté en figure 2 ;
les figures 10A à 10D sont des coupes, partielles et schématiques, de structures obtenues à des étapes successives d'un mode de réalisation d'un procédé de fabrication du dispositif optoélectronique selon l'invention revendiquée qui est représenté en figure 4 ; et
les figures 11A à 11C sont des coupes, partielles et schématiques, de structures obtenues à des étapes successives d'un mode de réalisation d'un procédé de fabrication du dispositif optoélectronique selon l'invention revendiquée qui est représenté en figure 6.

### Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. En outre, seuls les éléments utiles à la compréhension de la présente description ont été représentés et sont décrits. En particulier, les moyens de commande des dispositifs optoélectroniques décrits ci-après sont à la portée de l'homme de l'art et ne sont pas décrits. Dans la suite de la description, sauf indication contraire, les termes "sensiblement", "environ" et "de l'ordre de" signifient "à 10 % près".

La présente description concerne des dispositifs optoélectroniques comprenant des éléments semiconducteurs ayant la forme de microfils, de nanofils ou de pyramides.

Le terme "microfil" ou "nanofil" désigne une structure tridimensionnelle de forme allongée, par exemple cylindrique, conique ou tronconique, selon une direction privilégiée dont au moins deux dimensions, appelées dimensions mineures, sont comprises entre 5 nm et 2,5 um, de préférence entre 50 nm et 2,5 µm, la troisième dimension, appelée dimension majeure, étant supérieure ou égale à 1 fois, de préférence supérieure ou égale à 5 fois et encore plus préférentiellement supérieure ou égale à 10 fois, la plus grande des dimensions mineures. Dans certains modes de réalisation, les dimensions mineures peuvent être inférieures ou égales à environ 1 µm, de préférence comprises entre 10 nm et 1 µm, plus préférentiellement entre 20 nm et 800 nm. Dans certains modes de réalisation, la hauteur de chaque microfil ou nanofil peut être supérieure ou égale à 500 nm, de préférence comprise entre 1 µm et 50 µm.

Dans la suite de la description, on utilise le terme "fil" pour signifier "microfil ou nanofil". De préférence, la ligne moyenne du fil qui passe par les barycentres des sections droites, dans des plans perpendiculaires à la direction privilégiée du fil, est sensiblement rectiligne et est appelée par la suite "axe" du fil. La base du fil a, par exemple, une forme ovale, circulaire ou polygonale, notamment triangulaire, rectangulaire, carrée ou hexagonale. La section droite du fil peut être constante le long de l'axe du fil ou peut varier le long de l'axe du fil. A titre d'exemple, le fil peut avoir une forme cylindrique à base circulaire ou non circulaire, ou peut être de forme conique ou de forme tronconique.

Dans la suite de la description, le terme pyramide ou pyramide tronquée désigne une structure tridimensionnelle de forme pyramidale. Cette structure pyramidale peut être tronquée, c'est-à-dire que le haut du cône est absent, laissant place à un plateau. La base de la pyramide est inscrite dans un polygone dont la dimension des côtés est de 100 nm à 10 µm, préférentiellement entre 1 et 3 µm. Le polygone formant la base de la pyramide peut être un hexagone. La hauteur de la pyramide entre la base de la pyramide et le sommet ou le plateau sommital varie de 100 nm à 20 µm, préférentiellement entre 1 µm et 10 µm.

Dans la suite de la description, des modes de réalisation vont être décrits dans le cas d'un dispositif optoélectronique à diodes électroluminescentes. Toutefois, il est clair que ces modes de réalisation peuvent concerner d'autres applications, notamment des dispositifs dédiés à la détection ou la mesure d'un rayonnement électromagnétique ou des dispositifs dédiés aux applications photovoltaïques.

La figure 2 est une coupe, partielle et schématique, d'un dispositif optoélectronique 40 réalisé à partir de fils tels que décrits précédemment et adapté à émettre un rayonnement électromagnétique. Un mode de réalisation va maintenant être décrit pour un seul fil, sachant que la structure est répétée pour chaque fil.

Le dispositif 40 comprend, du bas vers le haut en figure 1 :
une première électrode de polarisation 42 et une deuxième électrode de polarisation 44 ;
un support 46 en un matériau isolant électriquement, comprenant une face inférieure 48 et une face supérieure 50, les première et deuxième électrodes 42, 44 s'étendant en partie sur la face inférieure 48 ;
un bloc 52 en un matériau conducteur électriquement ou semiconducteur reposant sur la face supérieure 50 du support 46 et en contact avec le support 46 et comprenant une face supérieure 54, du côté opposé au support 46, et des parois latérales 56, la première électrode 42 étant en contact avec le bloc 52 au travers du support 46 ;
une couche de nucléation 58, également appelée couche de germination, recouvrant la face supérieure 54 ;
un empilement recouvrant la couche de nucléation 58 comprenant une première couche isolante électriquement 60 et une deuxième couche isolante électriquement 62 ;
une ouverture 64 traversant les première et deuxième couches isolantes 60, 62 et exposant une portion de la couche de nucléation 58, une partie des flancs de l'ouverture 64 étant recouverts d'un revêtement isolant électriquement 66 ;
un revêtement isolant électriquement 68 recouvrant les flancs extérieurs du bloc 52, de la couche de nucléation 58 et des première et deuxième couches isolantes 60, 62, l'ensemble comprenant le bloc 52, la couche de nucléation 58, les première et deuxième couches isolantes 60, 62 et les revêtements isolants 66, 68 formant un piédestal 70 ;
un fil 72 d'axe D reposant sur le piédestal 70 ;
une coque 74 recouvrant le fil 72, la coque 74 comprenant la couche active de la diode électroluminescente, l'ensemble formé par le fil 72 et la coque 74 constituant une diode électroluminescente DEL ;
une couche isolante électriquement 76 recouvrant le support 46 et s'étendant sur les flancs latéraux du piédestal 70 et sur une partie inférieure de la coque 74 ;
une couche 78 conductrice électriquement et transparente au rayonnement émis par la couche active, recouvrant la coque 74 et la partie de la couche isolante 76 remontant sur la coque 74 ;
une couche 80 conductrice électriquement et réfléchissante au rayonnement émis par la couche active, s'étendant sur la couche 78 et autour de la diode électroluminescente DEL, la deuxième électrode 44 étant au contact de la couche conductrice 80 au travers du support 46 et de la couche isolante 76 ; et
une couche d'encapsulation 82 isolante électriquement et transparente au rayonnement émis par la couche active et recouvrant l'ensemble de la structure.

Lorsque plusieurs diodes électroluminescentes DEL sont formées sur le support 46, elles peuvent être connectées en série et/ou en parallèle et former un ensemble de diodes électroluminescentes. L'ensemble peut comprendre de quelques diodes électroluminescentes DEL à un millier de diodes électroluminescentes DEL. En particulier, la couche conductrice 80 peut relier plusieurs diodes électroluminescentes DEL.

Selon l'invention, en figure 2, on a représenté la couche 80 qui, dans la partie droite de la figure 2, s'étend sur la couche 76 au-delà de la couche 78 pour indiquer que la couche 80 peut être reliée à une autre diode électroluminescente, non représentée, qui serait située plus à droite, tandis que, en partie gauche de la figure 2, la couche 80 est représentée ne s'étendant pas vers la gauche au-delà de la couche 78 pour montrer le cas où la couche 80 n'est pas reliée à une diode électroluminescente, non représentée, qui serait située plus à gauche.

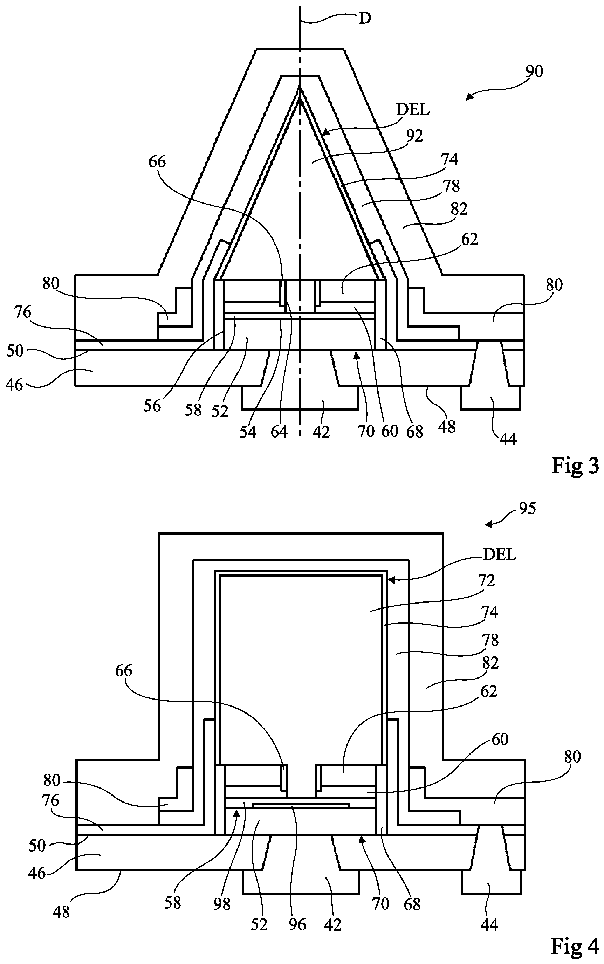

La figure 3 est une coupe, partielle et schématique, d'un dispositif optoélectronique 90. Le dispositif optoélectronique 90 comprend l'ensemble des éléments du dispositif optoélectronique 40 représenté en figure 2 à la différence que le fil 72 est remplacé par une pyramide 92 d'axe D reposant sur le piédestal 70.

Selon un mode de réalisation, la limite supérieure de la couche conductrice et réfléchissante 80 mesurée selon l'axe D à partir de la face 50 est inférieure à la limite supérieure de la couche isolante 62 et/ou de la couche isolante 76. De ce fait , et selon l'invention, la couche conductrice 80 ne recouvre pas les coques 74. De façon avantageuse, la couche conductrice 80 ne bloque alors pas les photons émis par les couches actives des coques 74 qui peuvent s'échapper hors des diodes électroluminescentes DEL. L'efficacité d'extraction du dispositif optoélectronique 40 ou 90 est ainsi augmentée.

L'épaisseur de la couche conductrice 80 du dispositif optoélectronique 40 ou 90 peut, de façon avantageuse, être augmentée par rapport à celle de la couche conductrice 34 du dispositif optoélectronique 10. La diffusion du courant vers les diodes électroluminescentes est ainsi améliorée.

Le support 46 peut être réalisé en un matériau isolant électriquement. Ceci permet, de façon avantageuse, de réaliser facilement une commande indépendante de chaque diode électroluminescente ou de groupes de diodes électroluminescentes sans devoir réaliser des tranchées d'isolation électrique dans le support 46.

Les éléments semiconducteurs tridimensionnels, qui correspondent au fil 72 ou à la pyramide 92 dans les modes de réalisation décrits précédemment, sont, au moins en partie, formés à partir d'au moins un matériau semiconducteur. Le matériau semiconducteur est choisi dans le groupe comprenant les composés III-V, les composés II-VI ou les semiconducteurs ou composés du groupe IV.

Les éléments semiconducteurs peuvent être, au moins en partie, formés à partir de matériaux semiconducteurs comportant majoritairement un composé III-V, par exemple un composé III-N. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires.

Les éléments semiconducteurs peuvent être, au moins en partie, formés à partir de matériaux semiconducteurs comportant majoritairement un composé II-VI. Des exemples d'éléments du groupe II comprennent des éléments du groupe IIA, notamment le béryllium (Be) et le magnésium (Mg) et des éléments du groupe IIB, notamment le zinc (Zn), le cadmium (Cd) et le mercure (Hg). Des exemples d'éléments du groupe VI comprennent des éléments du groupe VIA, notamment l'oxygène (O) et le tellure (Te). Des exemples de composés II-VI sont ZnO, ZnMgO, CdZnO, CdZnMgO, CdHgTe, CdTe ou HgTe. De façon générale, les éléments dans le composé II-VI peuvent être combinés avec différentes fractions molaires.

Les éléments semiconducteurs peuvent être, au moins en partie, formés à partir de matériaux semiconducteurs comportant majoritairement au moins un élément du groupe IV. Des exemples de matériaux semiconducteurs du groupe IV sont le silicium (Si), le carbone (C), le germanium (Ge), les alliages de carbure de silicium (SiC), les alliages silicium-germanium (SiGe) ou les alliages de carbure de germanium (GeC).

Les éléments semiconducteurs 72, 92 peuvent comprendre un dopant. A titre d'exemple, pour des composés III-V, le dopant peut être choisi dans le groupe comprenant un dopant de type P du groupe II, par exemple, du magnésium (Mg), du zinc (Zn), du cadmium (Cd) ou du mercure (Hg), un dopant du type P du groupe IV, par exemple du carbone (C) ou un dopant de type N du groupe IV, par exemple du silicium (Si), du germanium (Ge), du sélénium (Se), du soufre (S), du terbium (Tb) ou de l'étain (Sn). La concentration de dopants dans l'élément semiconducteur peut varier selon l'axe de l'élément semiconducteur. En particulier, lorsque les éléments semiconducteurs tridimensionnels du dispositif optoélectronique correspondent à des fils 72, la concentration de dopants peut être plus importante à la base du fil qu'au sommet du fil.

Les axes de deux éléments semiconducteurs 72, 92 adjacents peuvent être distants de 0,1 µm à 15 µm et de préférence de 0,3 µm à 5 µm. A titre d'exemple, les éléments semiconducteurs 72, 92 peuvent être régulièrement répartis, par exemple en rangées et/ou en colonnes.

Le support 46 est en un matériau isolant électriquement, par exemple en oxyde de silicium (SiO₂), en nitrure de silicium (SiₓN_{y}, où x est environ égal à 3 et y est environ égal à 4, par exemple du Si₃N₄), en oxynitrure de silicium (notamment de formule générale SiOₓN_{y}, par exemple du Si₂ON₂), en oxyde d'hafnium (HfO₂) ou en diamant. L'épaisseur du support 46 peut être comprise entre 100 nm et 2 µm, de préférence entre 0,3 µm et 1 µm.

Le bloc 52 est de préférence en un matériau semiconducteur, par exemple en silicium, en germanium, en carbure de silicium, en un composé III-V, tel que du GaN ou du GaAs, ou un substrat en ZnO. De préférence, le bloc 52 est en silicium monocristallin. Le bloc 52 peut être fortement dopé, faiblement dopé ou non dopé. Dans le cas où le substrat est fortement dopé, le bloc 52 peut être dopé de façon à baisser la résistivité électrique jusqu'à une résistivité proche de celle des métaux, de préférence inférieure à quelques mohm.cm. Dans le cas d'un bloc 52 en silicium, des exemples de dopants de type P sont le bore (B) ou l'indium (In) et des exemples de dopants de type N sont le phosphore (P), l'arsenic (As), ou l'antimoine (Sb). La face 54 du bloc 52 de silicium peut être une face (100) ou une face (111). La hauteur de chaque bloc 52, mesurée selon l'axe D, est comprise entre 0,3 µm et 7 µm et préférentiellement entre 1 µm et 4 µm. Le diamètre de chaque ouverture 64 peut varier de 10 nm à 1 µm.

En vue de dessus selon l'axe D, le diamètre du cercle inscrit dans le bloc 52 est sensiblement égal au diamètre maximal du cercle inscrit dans le fil 72 ou dans la base de la pyramide 92 reposant sur le bloc 52.

Chaque électrode 42, 44 peut être réalisée en un seul matériau conducteur électriquement ou correspondre à un empilement d'au moins deux couches en des matériaux conducteurs électriquement différents choisis dans le groupe comprenant le siliciure de nickel (NiSi), l'aluminium (Al), le siliciure d'aluminium (AISi), le titane (Ti), le nitrure de titane (TiN), le siliciure de titane (TiSi), un alliage de titane, nickel et or (TiNiAu), un alliage d'aluminium et de cuivre (AlCu), le cuivre (Cu), un alliage de titane et de tungstène (TiW), le ruthénium (Ru), l'argent (Ag) et le tungstène (W).

La couche de germination 58 est en un matériau favorisant la croissance des éléments semiconducteurs 72, 92. A titre d'exemple, le matériau composant la couche de germination 58 peut être un nitrure, un carbure ou un borure d'un métal de transition de la colonne IV, V ou VI du tableau périodique des éléments ou une combinaison de ces composés. A titre d'exemple, la couche de germination 58 peut être en nitrure d'aluminium (AlN), en oxyde d'aluminium (Al₂O₃), en bore (B), en nitrure de bore (BN), en titane (Ti), en nitrure de titane (TiN), en tantale (Ta), en nitrure de tantale (TaN), en hafnium (Hf), en nitrure d'hafnium (HfN), en niobium (Nb), en nitrure de niobium (NbN), en zirconium (Zr), en borure de zirconium (ZrB₂), en nitrure de zirconium (ZrN), en carbure de silicium (SiC), en nitrure et carbure de tantale (TaCN), ou en nitrure de magnésium sous la forme MgₓN_{y}, où x est environ égal à 3 et y est environ égal à 2, par exemple du nitrure de magnésium selon la forme Mg₃N₂. La couche de germination 58 peut être dopée du même type de conductivité que le bloc 52. La couche de germination 58 a, par exemple, une épaisseur comprise entre 1 nm et 200 nm, de préférence comprise entre 10 nm et 50 nm. La couche de germination 58 peut être composée d'un alliage ou d'un empilement d'un ou de plusieurs matériaux mentionnés dans la liste ci-dessus.

Le fait de dire qu'un composé à base d'au moins un premier élément et d'un deuxième élément a une polarité du premier élément ou une polarité du deuxième élément signifie que le matériau croît selon une direction privilégiée et que lorsque le matériau est coupé dans un plan perpendiculaire à la direction de croissance privilégiée, la face exposée comprend essentiellement des atomes du premier élément dans le cas de la polarité du premier élément ou des atomes du deuxième élément dans le cas de la polarité du deuxième élément.

Le matériau constituant la couche de germination 58 est choisi de façon à favoriser la croissance des éléments semiconducteurs selon une polarité donnée. Dans le cas d'éléments semiconducteurs en GaN, pour obtenir des fils 72, la couche de germination 58 peut favoriser la croissance du GaN avec la polarité N et, pour obtenir des pyramides 92, la couche de germination 58 peut favoriser la croissance du GaN avec la polarité Ga.

Les couches isolantes 60, 62, 76, et/ou les revêtements isolants 66, 68 peuvent être chacun en un matériau diélectrique, par exemple en oxyde de silicium (SiO₂), en nitrure de silicium (SiₓN_{y}, où x est environ égal à 3 et y est environ égal à 4, par exemple du Si₃N₄), en oxynitrure de silicium (notamment de formule générale SiOₓN_{y}, par exemple du Si₂ON₂), en oxyde d'hafnium (HfO₂) ou en diamant. A titre d'exemple, les couches isolantes 60 et 76 sont en SiO₂ et la couche isolante 62 et les revêtements 66, 68 sont en Si₃N₄.

A titre d'exemple, l'épaisseur de la couche isolante 60 est comprise entre 5 nm et 1 µm. A titre d'exemple, l'épaisseur de la couche isolante 62 est comprise entre 5 nm et 1 µm. A titre d'exemple, l'épaisseur de chaque revêtement isolant 66, 68 est comprise entre 20 nm et 500 nm. A titre d'exemple, l'épaisseur de la couche isolante 76 est comprise entre 20 nm et 1 µm. A titre de variante, les deux couches isolantes 60 et 62 peuvent correspondre à une unique couche isolante. La hauteur de la remontée de la couche isolante 76 sur les piédestaux 70 et les éléments semiconducteurs 72, 92 est supérieure à la hauteur des piédestaux 70.

La coque 74 comprend un empilement de plusieurs couches comprenant notamment :
- une couche active recouvrant l'élément semiconducteur tridimensionnel 72, 92 associé ;
- une couche intermédiaire de type de conductivité opposé à l'élément semiconducteur et recouvrant la couche active ; et
- une couche optionnelle de liaison recouvrant la couche intermédiaire et recouverte par la couche conductrice et transparente 78. L'épaisseur totale de la coque 74 est par exemple comprise entre 20 nm et 1 µm.

La couche active est la couche depuis laquelle est émise la majorité du rayonnement fourni par la diode électroluminescente élémentaire. Selon un exemple, la couche active peut comporter des moyens de confinement des porteurs de charge électrique, tels qu'un puits quantique unique ou des puits quantiques multiples. Elle est, par exemple, constituée d'une alternance de couches de GaN et de InGaN ayant des épaisseurs respectives de 5 à 20 nm (par exemple 8 nm) et de 1 à 15 nm (par exemple 2,5 nm). Les couches de GaN peuvent être dopées, par exemple de type N ou P. Selon un autre exemple, la couche active peut comprendre une seule couche d'InGaN, par exemple d'épaisseur supérieure à 10 nm.

La couche intermédiaire, par exemple dopée de type P, peut correspondre à une couche semiconductrice ou à un empilement de couches et permet la formation d'une jonction P-N ou P-I-N, la couche active étant comprise entre la couche intermédiaire de type P et l'élément semiconducteur 72, 92 de type N de la jonction P-N ou P-I-N.

La couche de liaison peut correspondre à une couche semiconductrice ou à un empilement de couches semiconductrices et permet la formation d'un contact ohmique entre la couche intermédiaire et la couche conductrice et transparente 78. A titre d'exemple, la couche de liaison peut être dopée très fortement du type opposé à l'élément semiconducteur, jusqu'à dégénérer la ou les couches semiconductrices, par exemple dopée de type P à une concentration supérieure ou égale à 10²⁰ atomes/cm³.

L'empilement de couches semiconductrices peut comprendre une couche de blocage d'électrons formée d'un alliage ternaire, par exemple en nitrure de gallium et d'aluminium (AlGaN) ou en nitrure d'indium et d'aluminium (AlInN) en contact avec la couche active et la couche intermédiaire, pour assurer une bonne répartition des porteurs électriques dans la couche active.

La couche conductrice et transparente 78 est adaptée à polariser la couche active 74 recouvrant l'élément semiconducteur 72, 92 et à laisser passer le rayonnement électromagnétique émis par la diode électroluminescentes DEL. Le matériau formant la couche 78 est un matériau transparent et conducteur tel que de l'oxyde d'indium-étain (ou ITO, acronyme anglais pour Indium Tin Oxide), de l'oxyde de zinc dopé ou non à l'aluminium, au bore ou au gallium, de l'oxyde d'étain, de l'oxyde d'indium dopé au gallium, au zinc, à l'étain ou au tungstène, du graphène ou un mélange de ces matériaux. A titre d'exemple, la couche 78 a une épaisseur comprise entre 5 nm et 500 nm, de préférence entre 20 nm et 100 nm.

La couche 80 est un matériau conducteur électriquement et réfléchissant le rayonnement émis par la couche active. La couche 80 peut être en un matériau choisi dans le groupe comprenant l'argent (Ag), l'or (Au), l'aluminium (Al), siliciure de nickel (NiSi), le siliciure d'aluminium (AISi), le rhodium (Rh), le AlCu. A titre d'exemple, la couche 80 a une épaisseur comprise entre 10 nm et 2 µm. La couche 80 peut comprendre une couche unique ou comprendre un empilement d'au moins deux couches, dont l'une peut assurer uniquement le contact électrique, par exemple une couche en un matériau choisi dans le groupe comprenant le titane (Ti), le nitrure de titane (TiN), le tungstène (W), le nitrure de tantale (TaN), le rhuthénium (Ru), ou le molybdène (Mo).

La couche d'encapsulation 82 est réalisée en un matériau isolant électriquement et transparent au moins partiellement au rayonnement émis par la couche active, par exemple en silicone, en nitrure de silicium (SiₓN_{y}, où x est environ égal à 3 et y est environ égal à 4, par exemple du Si₃N₄), en oxynitrure de silicium (notamment de formule générale SiOₓN_{y}, par exemple du Si₂ON₂) ou en oxyde d'hafnium (HfO₂). La couche d'encapsulation 82 peut avoir une structure monocouche ou une structure multicouche.

La figure 4 est une coupe, partielle et schématique, d'un dispositif optoélectronique 95. Le dispositif optoélectronique 95 comprend l'ensemble des éléments du dispositif optoélectronique 40 à la différence que la couche de nucléation 58 est formée d'un empilement d'une première couche 96 et d'une deuxième couche 98 en des matériaux différents. Chacune des couches 96 et 98 est dans l'un des matériaux favorisant la croissance des éléments semiconducteurs 72, 92 indiqués précédemment. La couche 98 est une couche conductrice électriquement en un matériau meilleur conducteur électrique que le matériau composant la couche 96. Le fil 72 est en contact avec la couche 98 et le bloc 52 est en contact avec la couche 96. L'épaisseur de la couche 96 et l'épaisseur de la couche 98 peuvent être comprises entre 5 nm et 100 nm. Selon un mode de réalisation, en vue de dessus selon l'axe D, le diamètre du cercle inscrit dans la couche 96 est inférieur au diamètre du cercle inscrit dans la couche 98 pour que la couche 98 soit en contact avec le bloc 52. La couche 98 permet notamment d'obtenir un bon contact électrique avec la couche 52.

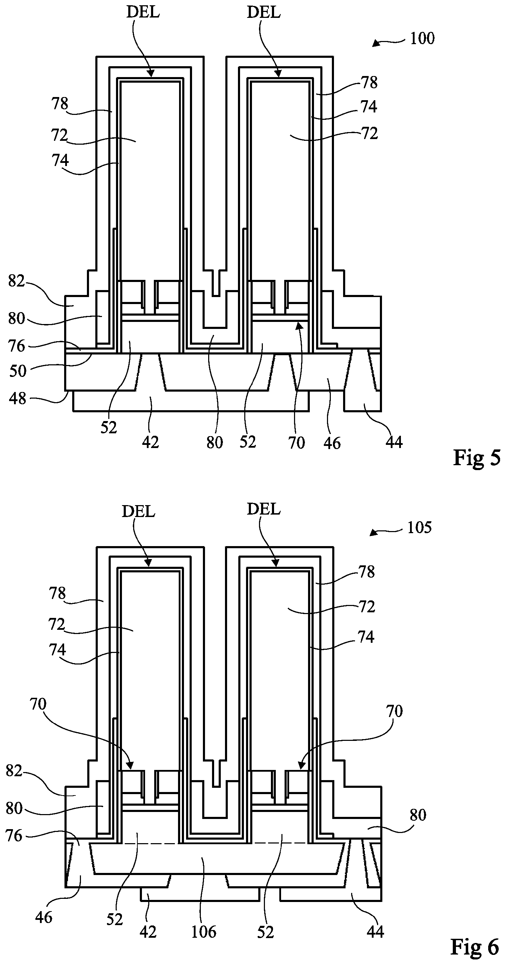

La figure 5 est une coupe, partielle et schématique, d'un dispositif optoélectronique 100. Le dispositif optoélectronique 100 comprend l'ensemble des éléments du dispositif optoélectronique 40 à la différence que l'électrode 42 est au contact des blocs 52 associés à deux diodes électroluminescentes DEL qui sont alors commandées en parallèle.

La figure 6 est une coupe, partielle et schématique, d'un dispositif optoélectronique 105. Le dispositif optoélectronique 105 comprend l'ensemble des éléments du dispositif optoélectronique 100 à la différence que le support 46 comprend, en outre, une portion semiconductrice 106 en contact avec les blocs 52 associés à deux diodes électroluminescentes DEL et composée, par exemple, du même matériau que les blocs 52. L'électrode 42 est en contact avec la portion semiconductrice 106.

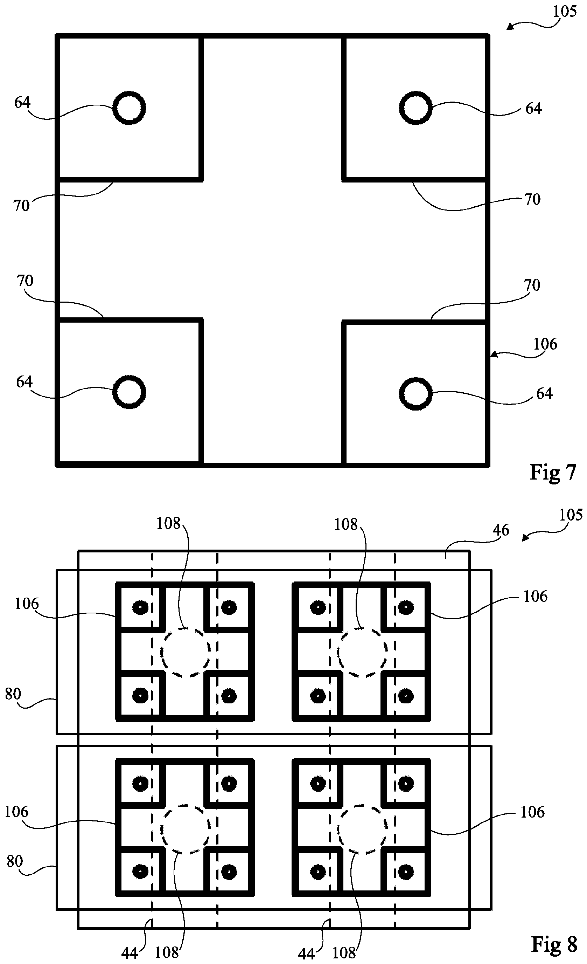

Les figures 7 et 8 sont des vues de dessus, partielles et schématiques, de modes de réalisation du dispositif optoélectronique 105 représenté en figure 6.

La figure 7 est une vue de dessus d'un mode de réalisation du dispositif optoélectronique 105 dans lequel on a représenté seulement la portion semiconductrice 106, ayant à titre d'exemple une forme carrée en vue de dessus, et quatre piédestaux 70 disposés aux quatre coins de la portion semiconductrice 106.

La figure 8 est une vue de dessus d'un mode de réalisation du dispositif optoélectronique 105 dans lequel on a représenté quatre portions semiconductrices 106 telles que représentées en figure 7 et comprenant chacune quatre piédestaux 70. Les portions semiconductrices 106 sont, à titre d'exemple, disposées sur deux rangées et sur deux colonnes. On a en outre représenté deux couches conductrices 80, chaque couche conductrice 80 ayant la forme d'une bande et étant associée à deux portions semiconductrices 106. On a en outre représenté deux électrodes 44 en traits pointillés ayant la forme de bandes s'étendant sensiblement de façon perpendiculaire par rapport aux couches conductrices 80. En outre, on a représenté en traits pointillés les zones de contact 108 entre les électrodes 44 et les couches conductrices 80.

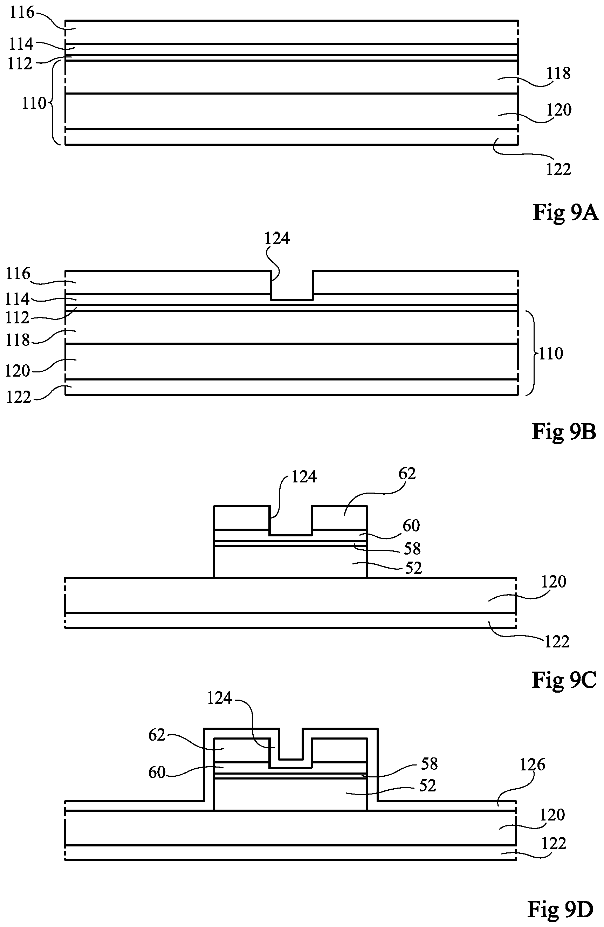

Les figures 9A à 9K sont des coupes, partielles et schématiques, de structures obtenues à des étapes successives d'un mode de réalisation d'un procédé de fabrication du dispositif optoélectronique 40 représenté en figure 2.

La figure 9A représente la structure obtenue après avoir fait croître successivement, sur un substrat 110, une couche de nucléation 112, une première couche isolante 114 et une deuxième couche isolante 116. La couche de nucléation 112 a la même épaisseur et la même composition que la couche de nucléation 58 décrite précédemment. La première couche isolante 114 a la même épaisseur et la même composition que la première couche isolante 60 décrite précédemment. La deuxième couche isolante 116 a la même épaisseur et la même composition que la deuxième couche isolante 62 décrite précédemment.

De préférence, le substrat 110 comprend une couche semiconductrice 118, du même matériau que le bloc 52, recouvrant un support constitué d'au moins un autre matériau. Le substrat 110 peut correspondre à une structure multicouches de type silicium sur isolant, également appelée SOI (acronyme anglais pour Silicon On Insulator), et comprendre la couche semiconductrice 118 recouvrant une couche isolante électriquement 120, qui correspond au support 46 décrit précédemment, la couche isolante 120 recouvrant un corps 122, par exemple en un matériau semiconducteur. Les matériaux constituant les couches 118 et 122 peuvent être de dopages et d'orientations cristallines différents.

Le procédé de croissance de la couche de nucléation 112 peut être un procédé du type dépôt chimique en phase vapeur (CVD, sigle anglais pour Chemical Vapor Déposition) ou dépôt chimique en phase vapeur organométallique (MOCVD, acronyme anglais pour Metal-Organic Chemical Vapor Déposition), également connu sous le nom d'épitaxie organométallique en phase vapeur (ou MOVPE, acronyme anglais pour Metal-Organic Vapor Phase Epitaxy). Toutefois, des procédés tels que l'épitaxie par jets moléculaires (MBE, acronyme anglais pour Molecular-Beam Epitaxy), la MBE à source de gaz (GSMBE), la MBE organométallique (MOMBE), la MBE assistée par plasma (PAMBE), l'épitaxie par couche atomique (ALE, acronyme anglais pour Atomic Layer Epitaxy) ou l'épitaxie en phase vapeur aux hydrures (HVPE, acronyme anglais pour Hydride Vapor Phase Epitaxy) peuvent être utilisés. En outre, des procédés tels que l'évaporation ou la pulvérisation cathodique réactive peuvent être utilisés.

Chaque couche isolante 114, 116 peut être déposée à titre d'exemple par dépôt chimique en phase vapeur assisté par plasma (PECVD, sigle anglais pour Plasma-Enhanced Chemical Vapor Déposition), dépôt chimique en phase vapeur à basse pression (LPCVD, sigle anglais pour Low-Pressure Chemical Vapor Déposition), dépôt chimique en phase vapeur à pression sous-atmosphérique (SACVD, sigle anglais pour Sub-Atmospheric Chemical Vapor Déposition), CVD, dépôt physique en phase vapeur (PVD, sigle anglais pour Physical Vapor Deposition), ou dépôt par couches atomiques (ALD, sigle anglais pour Atomic Layer Déposition).

La figure 9B représente la structure obtenue après avoir formé, pour chaque diode électroluminescente, une ouverture 124 dans la deuxième couche isolante 116 et dans une partie de la première couche isolante 114. De préférence, l'ouverture 124 ne s'étend pas jusqu'à la couche de nucléation 112. La gravure de la deuxième couche isolante 116 et de la première couche isolante 114 peut être une gravure par voie humide ou sèche (gravure au plasma).

La figure 9C représente la structure obtenue après avoir gravé successivement la deuxième couche isolante 116, la première couche isolante 114, la couche de nucléation 112 et la couche semiconductrice 118 pour délimiter, pour chaque diode électroluminescente, le bloc 52, la couche de nucléation 58, la première couche isolante 60 et la deuxième couche isolante 62.

Les gravures de la deuxième couche isolante 116, de la première couche isolante 114, de la couche de nucléation 112 et de la couche semiconductrice 118 peuvent être des gravures par voie humide ou sèche (gravure au plasma). De préférence, la couche isolante 120 forme une couche d'arrêt de gravure lors de la gravure de la couche semiconductrice 118. Ceci permet de commander avec précision la hauteur obtenue du piédestal 70.

La figure 9D représente la structure obtenue après avoir formé une couche isolante 126 sur la totalité de la structure obtenue à l'étape précédente, et notamment dans chaque ouverture 124 et sur les flancs latéraux de chaque bloc 52. La couche isolante 126 a la même épaisseur et la même composition que les revêtements 66, 68 décrits précédemment. La couche isolante 126 peut être réalisée par les procédés décrits précédemment pour la formation des couches isolantes 114, 116.

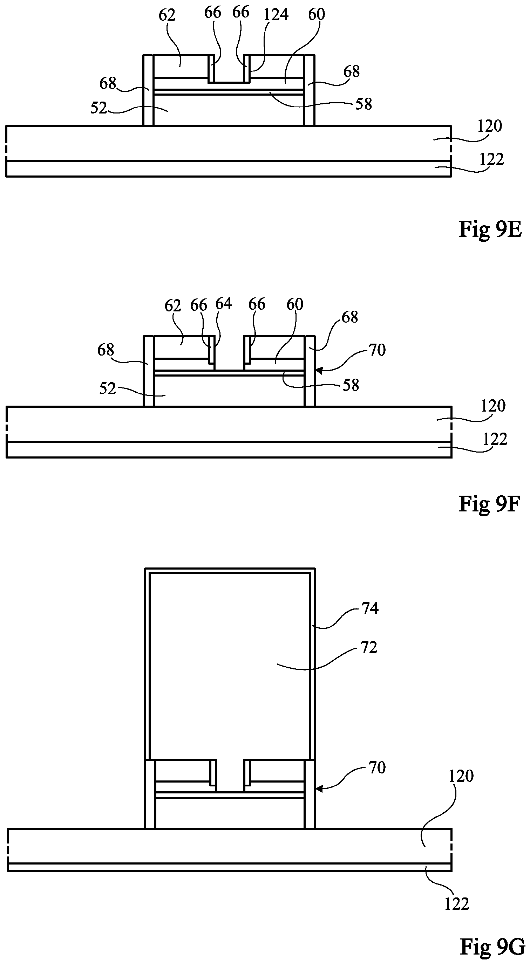

La figure 9E représente la structure obtenue après avoir gravé la couche isolante 126 pour ne conserver que le revêtement 66 sur les flancs latéraux de chaque ouverture 124 et le revêtement 68 sur les flancs externes de chaque bloc 52. L'arrêt de la gravure se fait sur la couche isolante 120 et sur la couche isolante 60. La gravure est une gravure anisotrope, par exemple une gravure sèche (notamment une gravure au plasma).

La figure 9F représente la structure obtenue après avoir prolongé chaque ouverture 124 jusqu'à atteindre la couche de nucléation 58 pour former l'ouverture 64 décrite précédemment. L'arrêt de gravure peut se faire sur la couche de nucléation 58. On obtient ainsi le piédestal 70 pour chaque diode électroluminescente. La présence du revêtement 66 permet de faire l'ouverture 64 avec un diamètre plus petit que le diamètre minimum qui pourrait être obtenu par des techniques de photolithographie.

La figure 9G représente la structure obtenue après avoir, pour chaque diode électroluminescente, fait croître, un fil 72 sur chaque piédestal 70 et une coque 74 recouvrant le fil 72.

Le procédé de croissance des fils 72 et des couches composant les coques 74 peut être un procédé du type CVD, MOCVD, MBE, GSMBE, MOMBE, PAMBE, ALE ou HVPE. De plus, des procédés électrochimiques peuvent également être utilisés, par exemple, le dépôt en bain chimique (CBD, sigle anglais pour Chemical Bath Déposition), les procédés hydrothermiques (également appelés procédés hydrothermaux), la pyrolyse d'aérosol liquide ou l'électrodépôt. Un exemple de procédé de formation des fils est décrit dans la demande de brevet US2015/0280053.

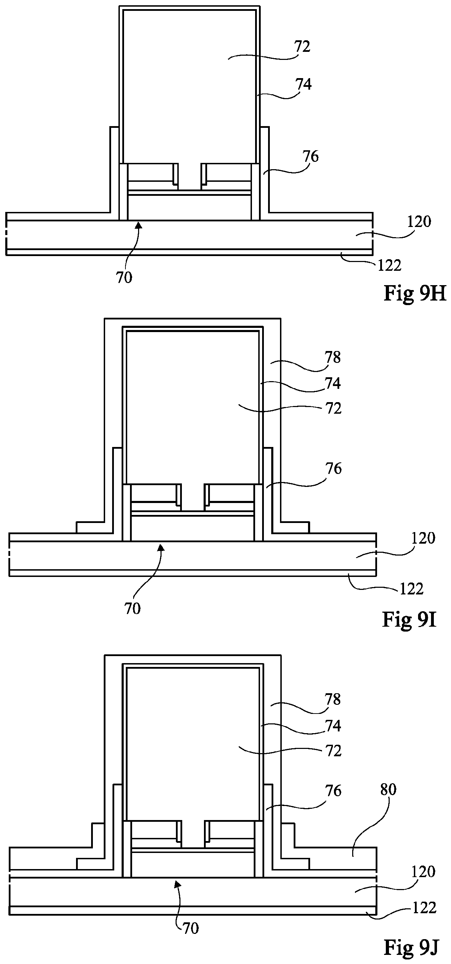

La figure 9H représente la structure obtenue après avoir formé la couche isolante 76. Ceci peut être obtenu en déposant une couche isolante sur la totalité de la structure obtenue à l'étape précédente, en déposant une couche de résine photosensible sur la totalité de la structure, en gravant partiellement la couche de résine pour exposer une partie supérieure de chaque coque 74 recouverte de la couche isolante et en gravant les portions de la couche isolante ainsi exposées. Un exemple de procédé de réalisation de la couche 76 est décrit dans la demande de brevet WO2016/108023.

La figure 9I représente la structure obtenue après avoir formé la couche conductrice et transparente 78. Ceci peut être obtenu en déposant une couche conductrice et transparente sur la totalité de la structure obtenue à l'étape précédente, en protégeant par un masque les parties à conserver de la couche conductrice et en retirant les portions de la couche conductrice et transparente non recouvertes du masque.

La figure 9J représente la structure obtenue après avoir formé la couche conductrice 80. Ceci peut être obtenu en déposant une couche conductrice sur la totalité de la structure obtenue à l'étape précédente, en déposant une couche de résine photosensible sur la totalité de la structure, en gravant partiellement la couche de résine pour exposer une partie supérieure de chaque fil 72 recouvert de la couche conductrice et en gravant les portions de la couche conductrice ainsi exposées.

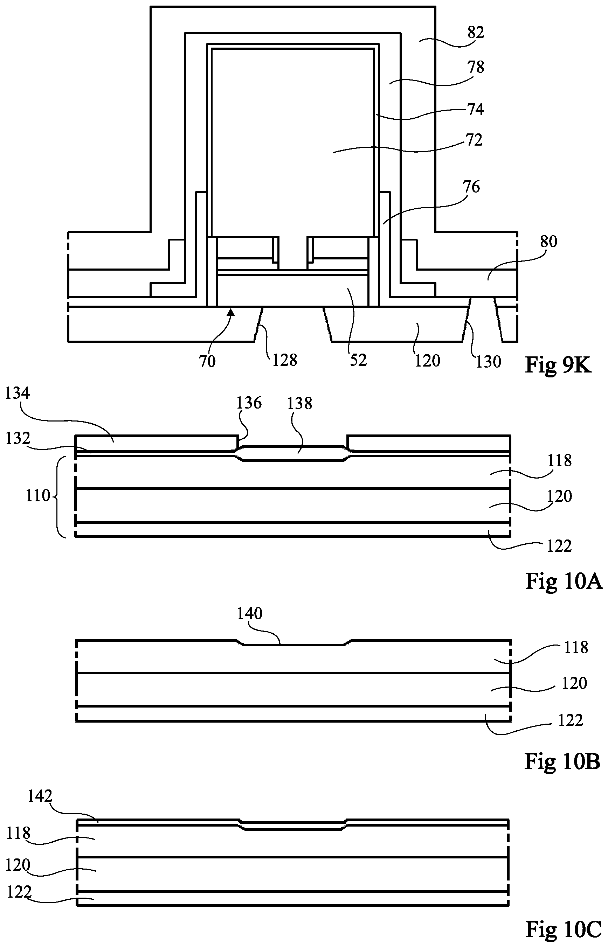

La figure 9K représente la structure obtenue après avoir formé la couche d'encapsulation 82, après avoir retiré le corps 122, par exemple par polissage, par planarisation mécano-chimique, ou par gravure chimique, et après avoir formé, pour chaque diode électroluminescente, une première ouverture 128 traversant de part en part la couche isolante 120 et exposant une partie du bloc 52 et une deuxième ouverture 130 traversant de part en part la couche isolante 120 et la couche isolante 76 et exposant une partie de la couche conductrice 80 comme cela est décrit dans la demande de brevet US2016/0218240.

Les étapes finales du procédé comprennent la formation de l'électrode 42 sur la face de la couche isolante 120 opposée au bloc 52 et dans l'ouverture 128 et la formation de l'électrode 44 sur la face de la couche isolante 120 opposée au bloc 52 et dans l'ouverture 130. Chaque électrode 42, 44 peut être formée, à titre d'exemple, par PVD, CVD, ALD ou par dépôt électrochimique (ECD, sigle anglais pour Electrochemical Déposition).

Les figures 10A à 10D sont des coupes, partielles et schématiques, de structures obtenues à des étapes successives d'un mode de réalisation d'un procédé de fabrication du dispositif optoélectronique 95 représenté en figure 4.

La figure 10A représente la structure obtenue après les étapes suivantes :
- dépôt d'une couche isolante électriquement 132 sur le substrat 110 décrit précédemment ;
- dépôt d'un masque 134 sur la couche isolante 132 ;
- formation d'une ouverture 136 dans le masque 134, et dans la couche isolante 132 pour exposer une partie de la couche semiconductrice 118 ; et
- réalisation par oxydation thermique d'une portion isolante électriquement 138 dans l'ouverture 136, la portion isolante 138 s'étendant en partie dans la couche semiconductrice 118, par exemple sur une profondeur comprise entre 10 nm et 200 nm.

La figure 10B représente la structure obtenue après avoir retiré le masque 134, la couche isolante 132 et la portion isolante 138. Il reste un évidement 140 en surface de la couche semiconductrice 118.

La figure 10C représente la structure obtenue après avoir déposé une première couche de germination 142 sur la totalité de la structure obtenue à l'étape précédente, et notamment dans l'évidement 140. La couche de germination 142 a la même épaisseur et la même composition que la couche de germination 96 décrite précédemment.

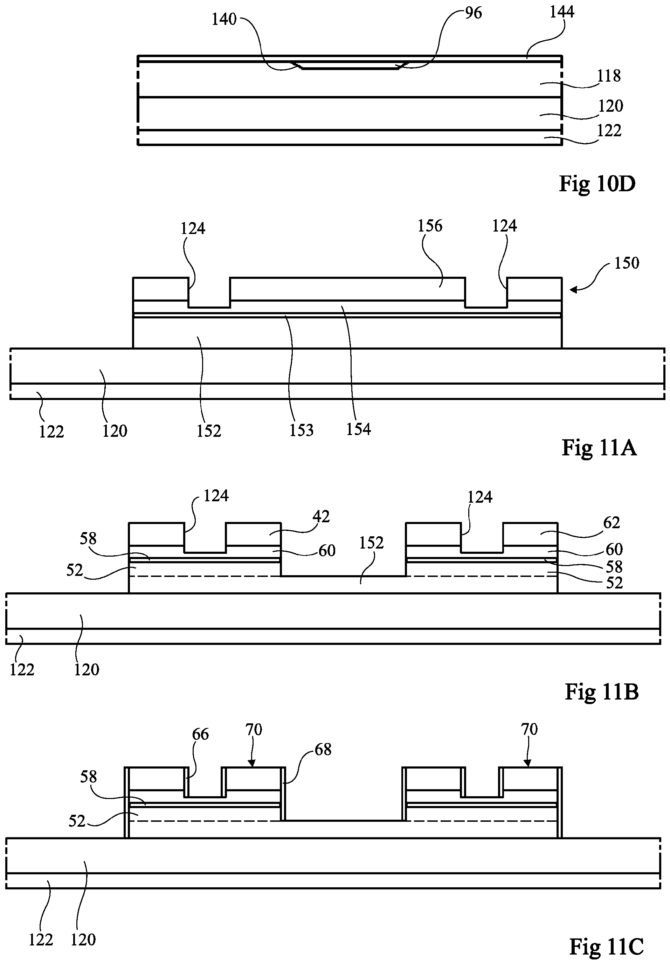

La figure 10D représente la structure obtenue après les étapes suivantes :
- retrait, par exemple par polissage ou planarisation mécano-chimique, de la partie de la couche de germination 142 en dehors de l'évidement 140 pour ne conserver que la couche de germination 96 dans l'évidement 140 ; et
- dépôt d'une couche de nucléation conductrice électriquement 144 sur la totalité de la structure ayant la même épaisseur et la même composition que la couche 98 décrite précédemment.

Les étapes suivantes peuvent être identiques aux étapes décrites précédemment en relation avec les figures 9B à 9J.

Les figures 11A à 11C sont des coupes, partielles et schématiques, de structures obtenues à des étapes successives d'un mode de réalisation d'un procédé de fabrication du dispositif optoélectronique 105 représenté en figure 6.

Les étapes initiales peuvent être identiques aux étapes décrites précédemment en relation avec les figures 9A et 9B.

La figure 11A représente la structure obtenue après avoir gravé successivement la deuxième couche isolante 116, la première couche isolante 114 et la couche semiconductrice 118 pour délimiter un îlot 150 formé par l'empilement d'une portion 152 de la couche semiconductrice 118, d'une portion 153 de la couche de nucléation 112, d'une portion 154 de la première couche isolante 114 et d'une portion 156 de la deuxième couche isolante 116, l'empilement comprenant au moins deux ouvertures 124.

La figure 11B représente la structure obtenue après avoir gravé successivement la portion isolante 156, la portion isolante 154, la portion de nucléation 153 et une partie de la portion semiconductrice 152 pour délimiter, pour chaque diode électroluminescente, le bloc 52, la couche de nucléation 58, la première couche isolante 60 et la deuxième couche isolante 62, les blocs 52 étant reliés électriquement les uns aux autres par le reste de la portion semiconductrice 152.

La figure 11C représente la structure obtenue après des étapes analogues à celles décrites précédemment en relation avec les figures 9D et 9E, ce qui conduit pour chaque piédestal 70 à la formation des revêtements 66 et 68.

Les étapes suivantes peuvent être identiques aux étapes décrites précédemment en relation avec les figures 9F à 9K.

Divers modes de réalisation avec diverses variantes ont été décrits ci-dessus. On note que l'homme de l'art peut combiner divers éléments de ces divers modes de réalisation et variantes sans faire preuve d'activité inventive. En particulier, dans les dispositifs optoélectroniques 95, 100, 105 décrits précédemment, les fils 72 peuvent être remplacés par des pyramides 92. Les modes de réalisation selon l'invention sont définis dans les revendications suivantes.

## Revendications

1. Dispositif optoélectronique (40 ; 90 ; 95 ; 100 ; 105) comprenant :
un support (46) ;
des blocs (52) d'un matériau semiconducteur, reposant sur le support et comprenant chacun une première face (54) du côté opposé au support et des parois latérales (56) ;
une couche de nucléation (58) sur chaque première face ;
une première couche isolante électriquement (60, 62) recouvrant chaque couche de nucléation (58) et comprenant une ouverture (64) exposant une partie de la couche de nucléation, pour chaque bloc (52), l'ensemble comprenant le bloc (52), la couche de nucléation (58), et la première couche isolante électriquement (60, 62) étant inclus dans un piédestal (70) ;
un élément semiconducteur (72, 92) reposant sur chaque première couche isolante et au contact de la couche de nucléation recouverte par ladite première couche isolante dans l'ouverture ;
une coque (74) recouvrant chaque élément semiconducteur et comprenant une couche active adaptée à émettre ou absorber un rayonnement électromagnétique ;
une deuxième couche isolante électriquement (76) recouvrant au moins une partie inférieure de chaque élément semiconducteur (72, 92) et s'étendant sur les flancs latéraux de chaque piédestal (70) et sur une partie inférieure de la coque (74) ;
une première couche conductrice électriquement (78), au moins en partie transparente audit rayonnement et recouvrant chaque coque (74) et la partie de la deuxième couche isolante électriquement (76) remontant sur la coque (74), la deuxième couche isolante électriquement (76) étant située entre la coque (74) et la première couche conductrice électriquement (78) ; et
une deuxième couche conductrice électriquement (80), réfléchissant ledit rayonnement, s'étendant entre les éléments semiconducteurs, s'étendant sur au moins une partie des parois latérales des blocs, et s'étendant sur la première couche conductrice électriquement (78), la première couche conductrice électriquement (78) étant située entre la deuxième couche conductrice électriquement (80) et la deuxième couche isolante électriquement (76), la deuxième couche conductrice ne recouvrant pas les coques (74)

2. Dispositif optoélectronique selon la revendication 1, comprenant, en outre, une couche d'encapsulation (82) isolante électriquement et au moins en partie transparente audit rayonnement et recouvrant les première et deuxième couches conductrices électriquement (78, 80).

3. Dispositif optoélectronique selon la revendication 1 ou 2, dans lequel chaque couche de nucléation (58) comprend au moins un empilement d'une troisième couche conductrice électriquement (98) au contact de l'élément semiconducteur (72, 92) associé et d'une quatrième couche (96) moins conductrice électriquement que la troisième couche conductrice, au contact du bloc (52) et recouvert par la troisième couche conductrice.

4. Dispositif optoélectronique selon l'une quelconque des revendications 1 à 3, dans lequel le support (46) comprend une troisième couche isolante électriquement (46) ayant des deuxième et troisième faces opposées (48, 50), les blocs (52) reposant sur la troisième face.

5. Dispositif optoélectronique selon la revendication 4, comprenant, en outre, au moins une première électrode (42) s'étendant en partie sur la quatrième face et au contact de l'un des blocs (52) au travers de la troisième couche isolante et au moins une deuxième électrode (44) au contact de la deuxième couche conductrice (80) au travers de la troisième couche isolante.

6. Dispositif optoélectronique selon l'une quelconque des revendications 1 à 5, dans lequel la hauteur de chaque bloc (52) est comprise entre 0,5 µm et 4 µm.

7. Dispositif optoélectronique selon l'une quelconque des revendications 1 à 6, comprenant une portion semiconductrice (106) au contact d'au moins deux des blocs (52).

8. Dispositif optoélectronique selon l'une quelconque des revendications 1 à 7 dans lequel l'élément semiconducteur est un nanofil, un microfil ou une pyramide (72, 92) de taille nanométrique ou micrométrique.

9. Dispositif optoélectronique selon l'une quelconque des revendications 1 à 8, dans lequel les éléments semiconducteurs (72, 92) sont, au moins en partie, en un matériau choisi dans le groupe comprenant les composés III-V, les composés II-VI ou les semiconducteurs ou composés du groupe IV.

10. Dispositif optoélectronique selon l'une quelconque des revendications 1 à 9, dans lequel chaque couche de nucléation (58) est au moins en partie en nitrure d'aluminium (AlN), en oxyde d'aluminium (Al₂O₃), en bore (B), en nitrure de bore (BN), en titane (Ti), en nitrure de titane (TiN), en tantale (Ta), en nitrure de tantale (TaN), en hafnium (Hf), en nitrure d'hafnium (HfN), en niobium (Nb), en nitrure de niobium (NbN), en zirconium (Zr), en borate de zirconium (ZrB₂), en nitrure de zirconium (ZrN), en carbure de silicium (SiC), en nitrure et carbure de tantale (TaCN), ou en nitrure de magnésium sous la forme MgₓN_{y}, où x est environ égal à 3 et y est environ égal à 2, par exemple du nitrure de magnésium selon la forme Mg₃N₂.

11. Procédé de fabrication d'un dispositif optoélectronique (40 ; 90 ; 95 ; 100 ; 105) comprenant les étapes suivantes :
former, sur un support (46), des blocs (52) d'un matériau semiconducteur comprenant chacun une première face (54) du côté opposé au support et des parois latérales (56), une couche de nucléation (58) sur chaque première face et une première couche isolante électriquement (60, 62) recouvrant chaque couche de nucléation (58) et comprenant une ouverture (64) exposant une partie de la couche de nucléation, pour chaque bloc (52), l'ensemble comprenant le bloc (52), la couche de nucléation (58), et la première couche isolante électriquement (60, 62) étant inclus dans un piédestal (70) ;
former un élément semiconducteur (72, 92) reposant sur chaque première couche isolante et au contact de la couche de nucléation recouverte par ladite première couche isolante dans l'ouverture ;
former une coque (74) recouvrant chaque élément semiconducteur et comprenant une couche active adaptée à émettre ou absorber un rayonnement électromagnétique ;
former une deuxième couche isolante électriquement (76) recouvrant au moins une partie inférieure de chaque élément semiconducteur (72, 92) et s'étendant sur les flancs latéraux de chaque piédestal (70) et sur une partie inférieure de la coque (74) ;
former une première couche conductrice électriquement (78), au moins en partie transparente audit rayonnement et recouvrant chaque coque (74) et la partie de la deuxième couche isolante électriquement (76) remontant sur la coque (74), la deuxième couche isolante électriquement (76) étant située entre la coque (74) et la première couche conductrice électriquement (78) ; et
former une deuxième couche conductrice électriquement (80), réfléchissant ledit rayonnement, s'étendant entre les éléments semiconducteurs, s'étendant sur au moins une partie des parois latérales des blocs, et s'étendant sur la première couche conductrice électriquement (78), la première couche conductrice électriquement (78) étant située entre la deuxième couche conductrice électriquement (80) et la deuxième couche isolante électriquement (76), la deuxième couche conductrice ne recouvrant pas les coques (74).

12. Procédé selon la revendication 11, comprenant, en outre, la formation d'une couche d'encapsulation (82) isolante électriquement et au moins en partie transparente audit rayonnement et recouvrant les première et deuxième couches conductrices électriquement (78, 80).

13. Procédé selon la revendication 11 ou 12, dans lequel le support (46) comprend une troisième couche isolante électriquement (46) ayant des deuxième et troisième faces opposées (48, 50), les blocs (52) étant formés sur la troisième face.

14. Procédé selon la revendication 13, comprenant, en outre, la formation d'au moins une première électrode (42) s'étendant en partie sur la quatrième face et au contact de l'un des blocs (52) au travers de la troisième couche isolante et la formation d'au moins une deuxième électrode (44) au contact de la deuxième couche conductrice (80) au travers de la troisième couche isolante.

15. Procédé selon l'une quelconque des revendications 11 à 14, comprenant la formation, sur le support d'une portion semiconductrice (106), et la formation sur la portion semiconductrice d'au moins deux des blocs (52) au contact de la portion semiconductrice.

## Patentansprüche

1. Ein optoelektronisches Gerät (40; 90; 95; 100; 105), das Folgendes aufweist:
ein Träger (46);
Blöcke (52) aus Halbleitermaterial, die auf dem Träger ruhen und jeweils eine erste Oberfläche (54) aufweisen, und zwar auf der Seite Gegenüber des Trägers und lateraler Wände (56);
eine Nukleierungsschicht (58) auf jeder ersten Oberfläche;
eine erste elektrisch isolierende Schicht (60, 62), die jede Nukleierungsschicht (58) bedeckt und eine Öffnung (64) aufweist, die einen Teil der Nukleierungsschicht offen legt, wobei für jeden Block (52) die Anordnung den Block (52), die Nukleierungsschicht (58) und die erste elektrisch isolierende Schicht (60, 62) aufweist, die in einem Sockel (70) beinhaltet sind;
ein Halbleiterelement (72,92), das auf jeder ersten isolierenden Schicht ruht und mit der Nukleierungsschicht in Kontakt ist, die von der ersten isolierenden Schicht bedeckt ist, und zwar in der Öffnung;
eine Schale (74), die jedes Halbleiterelement bedeckt und eine aktive Schicht aufweist, die in der Lage ist eine elektromagnetische Strahlung zu emittieren oder zu absorbieren;
eine zweite elektrisch isolierende Schicht (76), die wenigstens einen unteren Teil jedes Halbleiterelements (72, 92) bedeckt und sich über die lateralen Wände jedes Sockels (70) und über einen unteren Teil der Schale (74) erstreckt;
eine erste elektrisch leitende Schicht (78), die wenigstens teilweise transparent für die Strahlung ist und jede Schale (74) und den Teil der zweiten elektrisch isolierenden Schicht (76) bedeckt, der sich über die Schale (74) erstreckt, wobei die zweite elektrisch isolierende Schicht (76) zwischen der Schale (74) und der ersten elektrisch leitenden Schicht (78) angeordnet ist; und
eine zweite elektrisch leitende Schicht (80), die die Strahlung reflektiert und sich zwischen den Halbleiterelementen erstreckt, sich über wenigstens einen Teil der lateralen Wände der Blöcke erstreckt, und sich über die erste elektrisch isolierende Schicht (78) erstreckt, wobei die erste elektrisch isolierende Schicht (78) zwischen der zweiten elektrisch leitenden Schicht (80) und der zweiten elektrisch isolierenden Schicht (76) angeordnet ist, wobei die zweite elektrisch leitende Schicht die Schalen (74) nicht bedeckt.

2. Das optoelektronische Gerät nach Anspruch 1, das ferner eine elektrisch isolierende Kapselschicht (82) aufweist, die wenigstens teilweise transparent für die Strahlung ist und die erste und die zweite elektrisch leitende Schicht (78, 80) bedeckt.

3. Das optoelektronische Gerät nach Anspruch 1 oder 2, wobei jede Nukleierungsschicht (58) wenigstens einen Stapel aus einer dritten elektrisch leitenden Schicht (98) in Kontakt mit dem entsprechenden Halbleiterelement (72, 92) und aus einer vierten Schicht (96) aufweist, die weniger elektrisch leitend ist als die dritte leitende Schicht, in Kontakt mit dem Block (52) ist und bedeckt mit der dritten leitenden Schicht ist.

4. Das optoelektronische Gerät nach einem der Ansprüche 1 bis 3, wobei der Träger (46) eine dritte elektrisch isolierende Schicht (46) aufweist mit zweiten und dritten gegenüberliegenden Oberflächen (48, 50), wobei die Blöcke (52) auf der dritten Oberfläche ruhen.

5. Das optoelektronische Gerät nach Anspruch 4, das ferner wenigstens eine erste Elektrode (42) aufweist, die sich teilweise über die vierte Oberfläche erstreckt und in Kontakt mit einem der Blöcke (52) durch die dritte isolierende Schicht ist, und wenigstens eine zweite Elektrode (44) aufweist, die in Kontakt mit der zweiten leitenden Schicht (80) durch die dritte isolierende Schicht ist.

6. Das optoelektronische Gerät nach einem der Ansprüche 1 bis 5, wobei die Höhe jedes Blocks (52) im Bereich von 0.5 µm bis 4 µm liegt.

7. Das optoelektronische Gerät nach einem der Ansprüche 1 bis 6, das ferner einen Halbleiterteil (106) in Kontakt mit wenigstens zwei der Blöcke (52) aufweist.

8. Das optoelektronische Gerät nach einem der Ansprüche 1 bis 7, wobei das Halbleiterelement ein Nanodraht, ein Mikrodraht oder eine Nanometer- oder Mikrometer-Bereich-Pyramide (72, 92) ist.

9. Das optoelektronische Gerät nach einem der Ansprüche 1 bis 8, wobei die Halbleiterelemente (72, 92) wenigstens teilweise aus Material ausgewählt aus der Gruppe sind, die Folgendes aufweist: III-V Verbindungen, II-VI Verbindungen oder Gruppe-IV Halbleiter oder Verbindungen.

10. Das optoelektronische Gerät nach einem der Ansprüche 1 bis 9, wobei jede Nukleierungsschicht (58) wengistens teilweise hergestellt ist aus Aluminiumnitrid (AIN), aus Aluminium oxid (Al₂O₃), aus Bor (B), aus Bornitrid (BN), aus Titan (Ti), aus Titannitrid (TiN), aus Tantal (Ta), aus Tantalnitrid (TaN), aus Hafnium (Hf), aus Hafniumnitrid (HfN), aus Niob (Nb), aus Niobnitrid (NbN), aus Zirkon (Zr), aus Zirkonborat (ZrB₂),aus Zirkonnitrid (ZrN), aus Siliziumkarbid (SiC), aus Tantalkarbidnitrid (TaCN), aus Magnesiumnitrid in MgₓN_{y} -Form, wobei x in etwa gleich 3 und y in etwa gleich 2 ist, beispielsweise Magnesiumnitrid in Mg₃N₂ - Form.

11. Ein Verfahren zum Herstellen eines optoelektronischen Geräts (40; 90; 95; 100; 105), das Folgende Schritte aufweist:
Ausbilden, auf einem Träger (46), von Blöcken (52) eines Halbleitermaterials, die jeweils eine erste Oberfläche (54) aufweisen, und zwar auf der Seite Gegenüber des Trägers und lateraler Wände (56), eine Nukleierungsschicht (58) auf jeder ersten Oberfläche aufweisen, und eine erste elektrisch isolierende Schicht (60, 62) aufweisen, die jede Nukleierungsschicht (58) bedeckt und eine Öffnung (64) aufweist, die einen Teil der Nukleierungsschicht offenlegt, wobei für jeden Block (52), wobei die Anordnung den Block (52) aufweist, die Nukleierungsschicht (58) und die erste elektrisch isolierende Schicht (60, 62) in einem Sockel (70) beinhaltet sind;
Ausbilden eines Halbleiterelements (72, 92) , das auf jeder ersten isolierenden Schicht ruht und mit der Nukleierungsschicht in Kontakt ist, die von der ersten isolierenden Schicht bedeckt ist, und zwar in der Öffnung;
Ausbilden einer Schale (74), die jedes Halbleiterelement bedeckt und eine aktive Schicht aufweist, die in der Lage ist eine elektromagnetische Strahlung zu emittieren oder zu absorbieren;
Ausbilden einer zweiten elektrisch isolierenden Schicht (76), die wenigstens einen unteren Teil jedes Halbleiterelements (72, 92) bedeckt und sich über die lateralen Wände jedes Sockels (70) und über einen unteren Teil der Schale (74) erstreckt;
Ausbilden einer ersten elektrisch leitenden Schicht (78), die wenigstens teilweise transparent für die Strahlung ist und jede Schale (74) und den Teil der zweiten elektrisch isolierenden Schicht (76) bedeckt, der sich über die Schale (74) erstreckt, wobei die zweite elektrisch isolierende Schicht (76) zwischen der Schale (74) und der ersten elektrisch leitenden Schicht (78) angeordnet ist; und
Ausbilden einer zweiten elektrisch leitenden Schicht (80), die die Strahlung reflektiert und sich zwischen den Halbleiterelementen erstreckt, sich über wenigstens einen Teil der lateralen Wände der Blöcke erstreckt, und sich über die erste elektrisch isolierende Schicht (78) erstreckt, wobei die erste elektrisch isolierende Schicht (78) zwischen der zweiten elektrisch leitenden Schicht (80) und der zweiten elektrisch isolierenden Schicht (76) angeordnet ist, wobei die zweite elektrisch leitende Schicht die Schalen (74) nicht bedeckt.

12. Das Verfahren nach Anspruch 11, das ferner Ausbilden einer elektrisch isolierenden Kapselschicht (82) aufweist, die wenigstens teilweise transparent für die Strahlung ist und die erste und die zweite elektrisch leitende Schicht (78, 80) bedeckt.

13. Das Verfahren nach Anspruch 11 oder 12, wobei der Träger (46) eine dritte elektrisch isolierende Schicht (46) aufweist mit zweiten und dritten gegenüberliegenden Oberflächen (48, 50), wobei die Blöcke (52) auf der dritten Oberfläche ausgebildet werden.

14. Das Verfahren nach Anspruch 13, das ferner Ausbilden wenigstens einer ersten Elektrode (42) aufweist, die sich teilweise über die vierte Oberfläche erstreckt und in Kontakt mit einem der Blöcke (52) durch die dritte isolierende Schicht ist, und Ausbilden wenigstens eine zweiten Elektrode (44) aufweist, die in Kontakt mit der zweiten leitenden Schicht (80) durch die dritte isolierende Schicht ist.

15. Das Verfahren nach einem der Ansprüche 11 bis 14, aufweisend Ausbilden, auf dem Träger, eines Halbleiterteils (106), und Bilden, auf dem Halbleiterteil, von wenigstens zwei der Blöcke (52) in Kontakt mit dem Halbleiterteil.

## Claims

1. An optoelectronic device (40; 90; 95; 100; 105) comprising:
a support (46);
blocks (52) of a semiconductor material, resting on the support and each comprising a first surface (54) on the side opposite to the support and lateral walls (56);
a nucleation layer (58) on each first surface;
a first electrically-insulating layer (60, 62) covering each nucleation layer (58) and comprising an opening (64) exposing a portion of the nucleation layer, for each block (52), the assembly comprising the block (52), the nucleation layer (58), and the first electrically-insulating layer (60, 62) being included in a pedestal (70);
a semiconductor element (72, 92) resting on each first insulating layer and in contact with the nucleation layer covered with said first insulating layer in the opening;
a shell (74) covering each semiconductor element and comprising an active layer capable of emitting or of absorbing an electromagnetic radiation;
a second electrically-insulating layer (76) covering at least a lower portion of each semiconductor element (72, 92) and extending over the lateral walls of each pedestal (70) and over a lower portion of the shell (74);
a first electrically-conductive layer (78), at least partly transparent to said radiation and covering each shell (74) and the portion of the second electrically-insulating layer (76) extending over the shell (74), the second electrically-insulating layer (76) being located between the shell (74) and the first electrically-conductive layer (78); and
a second electrically-conductive layer (80), reflecting said radiation, extending between the semiconductor elements, extending over at least a portion of the lateral walls of the blocks, and extending over the first electrically-insulating layer (78), the first electrically-insulating layer (78) being located between the second electrically-conductive layer (80) and the second electrically-insulating layer (76), which second conductive layer does not cover the shells (74).

2. The optoelectronic device of claim 1, further comprising an electrically-insulating encapsulation layer (82) at least partly transparent to said radiation and covering the first and second electrically-conductive layers (78, 80).

3. The optoelectronic device of claim 1 or 2, wherein each nucleation layer (58) comprises at least one stack of a third electrically-conductive layer (98) in contact with the associated semiconductor element (72, 92) and of a fourth layer (96) less electrically conductive than the third conductive layer, in contact with the block (52) and covered with the third conductive layer.

4. The optoelectronic device of any of claims 1 to 3, wherein the support (46) comprises a third electrically-insulating layer (46) having second and third opposite surfaces (48, 50), the blocks (52) resting on the third surface.

5. The optoelectronic device of claim 4, further comprising at least one first electrode (42) partly extending over the fourth surface and in contact with one of the blocks (52) through the third insulating layer and at least one second electrode (44) in contact with the second conductive layer (80) through the third insulating layer.

6. The optoelectronic device of any of claims 1 to 5, wherein the height of each block (52) is in the range from 0.5 µm to 4 µm.

7. The optoelectronic device of any of claims 1 to 6, comprising a semiconductor portion (106) in contact with at least two of the blocks (52).

8. The optoelectronic device of any of claims 1 to 7, wherein the semiconductor element is a nanowire, a microwire, or a nanometer- or micrometer-range pyramid (72, 92).

9. The optoelectronic device of any of claims 1 to 8, wherein the semiconductor elements (72, 92) are, at least partly, made of a material selected from the group comprising III-V compounds, II-VI compounds, or group-IV semiconductors or compounds.

10. The optoelectronic device of any of claims 1 to 9, wherein each nucleation layer (58) is at least partly made of aluminum nitride (AlN), of aluminum oxide (Al₂O₃), of boron (B), of boron nitride (BN), of titanium (Ti), of titanium nitride (TiN), of tantalum (Ta), of tantalum nitride (TaN), of hafnium (Hf), of hafnium nitride (HfN), of niobium (Nb), of niobium nitride (NbN), of zirconium (Zr), of zirconium borate (ZrB₂), of zirconium nitride (ZrN), of silicon carbide (SiC), of tantalum carbide nitride (TaCN), of magnesium nitride in MgₓN_{y} form, where x is approximately equal to 3 and y is approximately equal to 2, for example, magnesium nitride in Mg₃N₂ form.

11. A method of manufacturing an optoelectronic device (40; 90; 95; 100; 105) comprising the steps of:
forming, on a support (46), blocks (52) of a semiconductor material, each comprising a first surface (54) on the side opposite to the support and the lateral walls (56), a nucleation layer (58) on each first surface and a first electrically-insulating layer (60, 62) covering each nucleation layer (58) and comprising an opening (64) exposing a portion of the nucleation layer, for each block (52), the assembly comprising the block (52), the nucleation layer (58), and the first electrically-insulating layer (60, 62) being included in a pedestal (70);
forming a semiconductor element (72, 92) resting on each first insulating layer and in contact with the nucleation layer covered with said first insulating layer in the opening;
forming a shell (74) covering each semiconductor element and comprising an active layer capable of emitting or absorbing an electromagnetic radiation;
forming a second electrically-insulating layer (76) covering at least a lower portion of each semiconductor element (72, 92) and extending over the lateral walls of each pedestal (70) and over a lower portion of the shell (74);
forming a first electrically-conductive layer (78), at least partly transparent to said radiation and covering each shell (74) and the portion of the second electrically-insulating layer (76) extending over the shell (74), the second electrically-insulating layer (76) being located between the shell (74) and the first electrically-conductive layer (78); and
forming a second electrically-conductive layer (80), reflecting said radiation, extending between the semiconductor elements, extending over at least a portion of the lateral walls of the blocks, and extending over the first electrically-insulating layer (78), the first electrically-insulating layer (78) being located between the second electrically-conductive layer (80) and the second electrically-insulating layer (76), which second conductive layer does not extend over the shells (74) .

12. The method of claim 11, further comprising forming an electrically-insulating encapsulation layer (82) at least partly transparent to said radiation and covering the first and second electrically-conductive layers (78, 80).

13. The method of claim 11 or 12, wherein the support (46) comprises a third electrically-insulating layer (46) having second and third opposite surfaces (48, 50), the blocks (52) being formed on the third surface.

14. The method of claim 13, further comprising forming at least one first electrode (42) partly extending over the fourth surface and in contact with one of the blocks (52) through the third insulating layer and forming at least one second electrode (44) in contact with the second conductive layer (80) through the third insulating layer.

15. The method of any of claims 11 to 14, comprising forming, on the support, a semiconductor portion (106), and forming, on the semiconductor portion, at least two of the blocks (52) in contact with the semiconductor portion.
